# EUROPEAN PATENT APPLICATION

(11) **EP 3 866 186 A1**
(43) Date of publication of application: **18.08.2021**
(21) Application number: 19880590.5
(22) Date of filing: 30.10.2019
(51) Int. Cl.: H01L 21/335, C30B 25/02

(54) **SILICON-BASED BASE, BASE SUBSTRATE AND MANUFACTURING METHOD THEREFOR, AND OPTOELECTRONIC DEVICE**

(30) Priority: 02.11.2018 CN 201811303611
(71) Applicant: Huawei Technologies Co., Ltd., Shenzhen, Guangdong 518129 (CN); Institute of Physics, Chinese Academy of Sciences, Beijing 100190 (CN)
(72) Inventor: ZHAO, Zhuang, Shenzhen, Guangdong 518129 (CN); LIU, Lei, Shenzhen, Guangdong 518129 (CN); LE, Nguyen Binh, Shenzhen, Guangdong 518129 (CN); WANG, Ting, Beijing 100190 (CN); ZHANG, Jianjun, Beijing 100190 (CN)
(74) Representative: Körber, Martin Hans
(86) International application number: PCT/CN2019/114307
(87) International publication number: WO 2020/088509

(57) **Abstract**

This application relates to the electronic technology application field and provides a silicon-based substrate (10), a substrate, a manufacturing method thereof, and an optoelectronic device. The substrate includes: the silicon-based substrate (10), where one surface of the silicon-based substrate (10) has periodic protrusion structures (101), and there is an angle of inclination between a side face of each protrusion structure (101) and a bottom surface; and a group III-V material layer (20) disposed on the surface that is of the silicon-based substrate (10) and that has the protrusion structures (101). In the substrate (10), one surface of the silicon-based substrate (10) is no longer a silicon (100) crystal plane, but has the periodic protrusion structures (101), dislocation can be self-annihilated by using the protrusion structures (101), and dislocation caused by lattice mismatch and an antiphase domain is limited to the silicon-based substrate (10), so that a group III-V material can maintain an orderly crystal structure when epitaxially growing on the silicon-based substrate (10). Therefore, problems of lattice mismatch and an antiphase domain between the silicon-based substrate (10) and the group III-V material are reduced, and a yield rate of the group III-V material on the silicon-based substrate (10) is improved. This application is used to form a high-quality group III-V material on the silicon-based substrate (10).

## Description

This application claims priority to Chinese Patent Application No. 201811303611.8, filed on November 2, 2018 and entitled "SILICON-BASED SUBSTRATE, SUBSTRATE, MANUFACTURING METHOD THEREOF, AND OPTOELECTRONIC DEVICE", which is incorporated herein by reference in its entirety.

### TECHNICAL FIELD

The present disclosure relates to the electronic technology application field, and in particular, to a silicon-based substrate, a substrate, a manufacturing method thereof, and an optoelectronic device.

### BACKGROUND

A silicon-based optoelectronic integration technology is a technology for integrating an optoelectronic device on a silicon-based substrate. Devices such as a light source, an amplifier, or a modulator formed by using this technology have advantages such as low costs, a micro dimension, and high integration.

However, because silicon is an indirect band-gap material and has a relatively poor performance of light-emitting, and a group III-V (also referred to as a group III-V) material has an excellent optical performance, the group III-V material can be prepared on the silicon-based substrate to form a highly efficient light-emitting device, thereby providing a good basis for forming the optoelectronic device. For example, the group III-V material may be indium arsenide (indium arsenide, InAs) or gallium arsenide (gallium arsenide, GaAs).

However, there are problems of lattice mismatch and an antiphase domain between a silicon (100) crystal plane and the group III-V material. Consequently, it is extremely difficult to form the group III-V material on a silicon-based substrate with the silicon (100) crystal plane.

### SUMMARY

This application provides a silicon-based substrate, a substrate, a manufacturing method thereof, and an optoelectronic device, to reduce problems of lattice mismatch and an antiphase domain between a silicon-based substrate and a group III-V material, and improve a yield rate of the group III-V material on the silicon-based substrate.

According to a first aspect, this application provides a substrate, including:
a silicon-based substrate, where one surface of the silicon-based substrate has periodic protrusion structures, there is an angle of inclination between a side face of each protrusion structure and a bottom surface, and dislocation of the silicon-based substrate can be self-annihilated by using the angle of inclination, so that the dislocation is suppressed on the side face of the protrusion structure of the silicon-based substrate; and
a group III-V material layer disposed on the surface that is of the silicon-based substrate and that has the protrusion structures.

In the substrate, one surface of the silicon-based substrate is no longer a silicon (100) crystal plane, but has the periodic protrusion structures, the dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

Optionally, the surface that is of the silicon-based substrate and that has the periodic protrusion structures is a silicon (111) crystal plane.

The silicon (111) crystal plane can effectively suppress the dislocation, so that the dislocation no longer grows upward, and the antiphase domain can be approximately completely suppressed on a 60° crystal plane, thereby facilitating epitaxial growth of the group III-V material.

Optionally, the silicon-based substrate includes a silicon-based sub-substrate with periodic grooves on one surface, and a silicon intermediate layer disposed on the surface that is of the silicon-based sub-substrate and that has the grooves, where the silicon intermediate layer includes the periodic protrusion structures; and
each protrusion structure is located on a spacing structure between two adjacent grooves, and side faces of every two adjacent protrusion structures are adjacent to each other (in other words, upper surfaces of the plurality of protrusion structures are consecutive surfaces), so that a stable silicon-based substrate structure can be implemented.

Optionally, an arrangement period of the grooves is 200 nanometers (nanometer, nm) to 800 nm, and a depth of each groove is 200 nm to 1000 nm. Further, the arrangement period of the grooves is 300 nm to 500 nm, and the depth of each groove is 400 nm to 600 nm.

Optionally, a thickness of the silicon intermediate layer is 300 nm to 800 nm, and the thickness of the silicon intermediate layer is a thickness of the silicon intermediate layer by using a top platform of a groove 111 as a reference surface. Further, the thickness of the silicon intermediate layer is 450 nm to 650 nm.

There may be a plurality of types of grooves. In an optional implementation, the surface that is of the silicon-based sub-substrate and that has the periodic grooves is a silicon (110) crystal plane, and a side boundary of each groove is perpendicular to the bottom surface.

In another optional implementation, an interface of the groove is an inverted trapezoid, a top width of each groove is 100 nm to 400 nm, and a bottom width of each groove is 50 nm to 200 nm. Further, the top width of each groove is 120 nm to 160 nm, and the bottom width of each groove is 100 nm to 120 nm.

Optionally, the group III-V material layer includes a group III-V material buffer layer and a group III-V dislocation filter layer that are successively superposed on the surface that is of the silicon-based substrate and that has the protrusion structures, the group III-V material buffer layer is used to buffer lattice mismatch of the silicon-based substrate, and the group III-V dislocation filter layer is used to filter dislocation of the silicon-based substrate.

Optionally, a thickness of the group III-V dislocation filter layer is 0 microns (micron, µm) to 2 µm, and surface roughness of the group III-V dislocation filter layer is 0.5 nm to 1.6 nm. Further, the thickness of the group III-V dislocation filter layer is 0.8 µm to 1.8 µm, and the surface roughness of the group III-V dislocation filter layer is 0.8 nm to 1.4 nm. The surface roughness may represent smoothness of a surface of a structure layer. A smaller value of the surface roughness indicates a smoother surface of the structure layer.

Optionally, the group III-V material buffer layer includes:
an AlAs (aluminum arsenide) crystal layer and a GaAs (gallium arsenide) crystal layer that are successively superposed on the surface that is of the silicon-based substrate and that has the protrusion structures.

Because a melting point of Al (aluminum) is approximately 660°C (degrees Celsius), and a melting point of Ga (gallium) is approximately 30°C, a melting point of the AlAs crystal layer is higher than a melting point of the GaAs crystal layer. When the GaAs crystal layer is directly disposed on the protrusion structures, because the melting point of Ga is relatively low, an atom at the GaAs crystal layer moves on the silicon-based substrate, thereby generating dislocation. When the AlAs crystal layer is disposed on the protrusion structures, because the melting point of A1 is relatively high, an atom at the AlAs crystal layer has higher bond energy, and does not move on the silicon-based substrate, thereby avoiding dislocation caused by the lattice mismatch. Therefore, if the AlAs crystal layer is first disposed on the protrusion structures of the silicon-based substrate, and then the GaAs crystal layer is disposed on the AlAs crystal layer, dislocation caused by directly disposing the GaAs crystal layer on the silicon-based substrate can be effectively avoided, thereby forming a high-quality group III-V material layer on the silicon-based substrate.

Optionally, a thickness of the group III-V material buffer layer is 0 nm to 600 nm, and surface roughness of the GaAs crystal layer is 0.5 nm to 1.6 nm. Further, the thickness of the group III-V material buffer layer is 200 nm to 600 nm, and the surface roughness of the GaAs crystal layer is 0.8 nm to 1.4 nm.

Optionally, the group III-V dislocation filter layer includes superposed first quantum well structure layers of m periods, where the first quantum well structure layer of each period includes an In_{0.15}Ga_{0.85}As crystal layer and a GaAs crystal layer that are successively superposed, and m is a positive integer. In_{0.15}Ga_{0.85}As represents InGaAs (indium gallium arsenide) in which a proportion of In (indium) is 15% and a proportion of Ga is 85%.

In the first quantum well structure layer, because lattice of In_{0.15}Ga_{0.85}As is larger than lattice of GaAs, stress is generated when the In_{0.15}Ga_{0.85}As crystal layer is first disposed on the group III-V material buffer layer, so that a stress field is formed. The stress field generated by the In_{0.15}Ga_{0.85}As crystal layer can offset stress generated by the dislocation, thereby suppressing the dislocation from continuing to extend upward.

Optionally, the group III-V dislocation filter layer further includes second quantum well structure layers of n periods and superlattice structures of p periods that are superposed on the first quantum well structure layers of the m periods, where the second quantum well structure layers of the n periods are superposed, the superlattice structures of the p periods are superposed, and n and p are positive integers;
the second quantum well structure layer of each period includes an In_{0.15}Al_{0.85}As crystal layer and a GaAs crystal layer that are successively superposed; and
the superlattice structure of each period includes an Al_{0.6}Ga_{0.4}As crystal layer and a GaAs crystal layer that are successively superposed.

The In_{0.15}Al_{0.85}As crystal layer in the second quantum well structure layer has a better dislocation suppression effect than the In_{0.15}Ga_{0.85}As crystal layer in the first quantum well structure layer. However, because the melting point of Al is higher than that of Ga, if the In_{0.15}Al_{0.85}As crystal layer is directly formed on the group III-V material buffer layer, movement of an Al atom is relatively difficult, and when a location of the atom is incorrect, adjustment is difficult. Consequently, it is difficult to suppress extension of the dislocation. When the first quantum well structure layer is first grown on the group III-V material buffer layer, and then the second quantum well structure layer is grown on the first quantum well structure layer, the In_{0.15}Ga_{0.85}As crystal layer is used as a padding, and then the In_{0.15}Al_{0.85}As crystal layer is formed, so that the dislocation can be better suppressed. Therefore, a high-quality group III-V material layer is formed on the silicon-based substrate.

In the second quantum well structure layer, dislocation may also be generated when there are excessive Al atoms. Therefore, the second quantum well structure layer includes the In_{0.15}Al_{0.85}As crystal layer and the GaAs crystal layer that are successively superposed, so that the dislocation caused by the excessive Al atoms can be effectively suppressed.

In the superlattice structure, the Al_{0.6}Ga_{0.4}As crystal layer and the GaAs crystal layer that are successively superposed may make a surface of a finally formed group III-V dislocation filter layer flat and smooth, to obtain a high-quality substrate.

Optionally, m=n=p=5. In this case, the thickness of the group III-V dislocation filter layer is relatively thin, and a better dislocation suppression effect can be implemented. Larger values of m, n, and p indicate a better dislocation suppression effect of the group III-V filter layer.

According to a second aspect, a silicon-based substrate is provided and includes:
a silicon-based sub-substrate with periodic grooves on one surface, and a silicon intermediate layer disposed on the grooves, where the silicon intermediate layer includes the periodic protrusion structures;
each protrusion structure is located on a spacing structure between two adjacent grooves, and side faces of every two adjacent protrusion structures are adjacent to each other; and
a surface that is of the silicon-based substrate and that has the periodic protrusion structures is a silicon (111) crystal plane.

Optionally, the surface that is of the silicon-based sub-substrate and that has the periodic grooves is a silicon (110) crystal plane.

According to a third aspect, a substrate manufacturing method is provided and includes:
manufacturing a silicon-based substrate, where one surface of the silicon-based substrate has periodic protrusion structures, and there is an angle of inclination between a side face of each protrusion structure and a bottom surface; and
forming a group III-V material layer on the surface that is of the silicon-based substrate and that has the protrusion structures.

In the substrate manufactured by using this manufacturing method, because one surface of the silicon-based substrate is no longer a silicon (100) crystal plane, but has the periodic protrusion structures, dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

The surface that is of the silicon-based substrate and that has the periodic protrusion structures is a silicon (111) crystal plane.

Optionally, the manufacturing a silicon-based substrate includes:
manufacturing a silicon-based sub-substrate with periodic grooves on one surface; and
forming a silicon intermediate layer on the surface that is of the silicon-based sub-substrate and that has the grooves, where the silicon intermediate layer includes the periodic protrusion structures, each protrusion structure is located on a spacing structure between two adjacent grooves, and every two adjacent protrusion structures are adjacent to each other.

The surface that is of the silicon-based sub-substrate and that has the periodic grooves is a silicon (110) crystal plane. In this case, the manufacturing a silicon-based sub-substrate with periodic grooves on one surface includes:
providing a silicon chip, where a surface of the silicon chip is a silicon (100) crystal plane; and
etching the silicon chip through a deep ultraviolet photolithography process, to obtain the silicon-based sub-substrate.

Optionally, the forming a silicon intermediate layer on the surface that is of the silicon-based sub-substrate and that has the grooves includes:
forming, by using a molecular beam epitaxial growth technology, the silicon intermediate layer on the surface that is of the silicon-based sub-substrate and that has the grooves.

The forming a group III-V material layer on the surface that is of the silicon-based substrate and that has the protrusion structures includes: forming, by using the molecular beam epitaxial growth technology, the group III-V material layer on the surface that is of the silicon-based substrate and that has the protrusion structures.

Optionally, the group III-V material layer may be formed, by using the molecular beam epitaxial growth technology, on the surface that is of the silicon-based substrate and that has the protrusion structures. In this case, the forming, by using the molecular beam epitaxial growth technology, the group III-V material layer on the surface that is of the silicon-based substrate and that has the protrusion structures includes:
forming, by using the molecular beam epitaxial growth technology, a group III-V material buffer layer on the surface that is of the silicon-based substrate and that has the protrusion structures; and
forming, by using the molecular beam epitaxial growth technology, a group III-V dislocation filter layer on the group III-V material buffer layer, where
the group III-V material buffer layer is used to buffer lattice mismatch of the silicon-based substrate, and the group III-V dislocation filter layer is used to filter dislocation of the silicon-based substrate.

Optionally, the group III-V material buffer layer includes an AlAs crystal layer and a GaAs crystal layer, and the GaAs crystal layer includes a first GaAs crystal sub-layer and a second GaAs crystal sub-layer.

The group III-V material layer may be formed, by using a three-step method, on the surface that is of the silicon-based substrate and that has the protrusion structures. In this case, the forming, by using the molecular beam epitaxial growth technology, a group III-V material buffer layer on the surface that is of the silicon-based substrate and that has the protrusion structures includes:
growing, at 350°C to 400°C by using the molecular beam epitaxial growth technology, the AlAs crystal layer whose thickness is 5 nm to 15 nm on the surface that is of the silicon-based substrate and that has the protrusion structures;
growing, at 350°C to 400°C by using the molecular beam epitaxial growth technology, the first GaAs crystal sub-layer whose thickness is 20 nm to 40 nm on the AlAs crystal layer; and
growing, at 550°C to 600°C by using the molecular beam epitaxial growth technology, the second GaAs crystal sub-layer whose thickness is 400 nm to 600 nm on the first GaAs crystal sub-layer.

The group III-V dislocation filter layer includes superposed first quantum well structure layers of m periods, where the first quantum well structure layer includes an In_{0.15}Ga_{0.85}As crystal layer and a GaAs crystal layer that are successively superposed, and m is a positive integer.

First, the first GaAs crystal sub-layer is grown in a low-temperature growth environment, so that a rate of growing the first GaAs crystal sub-layer on the surface that is of the silicon-based substrate and that has the protrusion structures can be reduced, and further, each atom at the first GaAs crystal sub-layer can be grown in a correct location. A high-quality second GaAs crystal sub-layer is then grown on the first GaAs crystal sub-layer in a high-temperature growth environment, so that dislocation caused by an antiphase domain can be suppressed, and a high-quality group III-V material layer is formed on the silicon-based substrate.

Optionally, the group III-V dislocation filter layer further includes second quantum well structure layers of n periods and superlattice structures of p periods that are superposed on the first quantum well structure layers of the m periods, where the second quantum well structure layers of the n periods are superposed, the superlattice structures of the p periods are superposed, and n and p are positive integers;
the second quantum well structure layer of each period includes an In_{0.15}Al_{0.85}As crystal layer and a GaAs crystal layer that are successively superposed; and
the superlattice structure of each period includes an Al_{0.6}Ga_{0.4}As crystal layer and a GaAs crystal layer that are successively superposed.

The first quantum well structure layers of the m periods may be first formed on the group III-V material buffer layer by using the molecular beam epitaxial growth technology, and then the second quantum well structure layers of the n periods are formed on the first quantum well structure layers, and finally, the superlattice structures of the p periods are formed on the second quantum well structure layers, to ensure an orderly structure of each layer.

Optionally, m=n=p=5.

A growth temperature of the first quantum well structure layer is 460°C to 510°C, and both a thickness of the In_{0.15}Ga_{0.85}As crystal layer and a thickness of the GaAs crystal layer are 10 nm. A growth temperature of the second quantum well structure layer is 460°C to 510°C, and both a thickness of the In_{0.15}Al_{0.85}As crystal layer and a thickness of the GaAs crystal layer are 10 nm. A growth temperature of the superlattice structure is 550°C to 600°C, and both a thickness of the Al_{0.6}Ga_{0.4}As crystal layer and a thickness of the GaAs crystal layer are 2 nm.

According to a fourth aspect, an optoelectronic device is provided and includes the substrate according to the first aspect, and at least one optical film layer and/or at least one electrical film layer disposed on the substrate.

Optionally, the optoelectronic device is a quantum dot laser, a detector, an amplifier, a modulator, a complementary metal-oxide-semiconductor CMOS electrical device, or a waveguide device.

Technical solutions provided in this application include at least the following beneficial effects:

According to the silicon-based substrate, the substrate, the manufacturing method thereof, and the optoelectronic device provided in this application, because one surface of the silicon-based substrate is no longer a silicon (100) crystal plane, but has periodic protrusion structures, dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

### BRIEF DESCRIPTION OF DRAWINGS

FIG. 1 is a schematic diagram of a cross-section of a substrate according to an embodiment of the present invention;
FIG. 2 is a schematic diagram of a cross-section of another substrate according to an embodiment of the present invention;
FIG. 3 is a schematic diagram of an enlarged part of a substrate according to an embodiment of the present invention;
FIG. 4 is a schematic diagram of a cross-section of a silicon-based substrate according to an embodiment of the present invention;
FIG. 5 is a schematic diagram of a cross-section of another silicon-based substrate according to an embodiment of the present invention;
FIG. 6 is a schematic diagram of comparison of surface scanning electron micrographs according to an embodiment of the present invention;
FIG. 7 is a schematic diagram of an X-ray diffraction spectrum of a substrate according to an embodiment of the present invention;
FIG. 8 is a flowchart of a substrate manufacturing method according to an embodiment of the present invention;
FIG. 9 is a flowchart of a silicon-based substrate manufacturing method according to an embodiment of the present invention;
FIG. 10 is a schematic diagram of a cross-section of a silicon-based sub-substrate according to an embodiment of the present invention;
FIG. 11 is a schematic diagram of growth of a 250 nm silicon intermediate layer on a silicon-based sub-substrate according to an embodiment of the present invention;
FIG. 12 is a flowchart of a method for forming a group III-V material layer according to an embodiment of the present invention;
FIG. 13 is a flowchart of a method for forming a group III-V material buffer layer according to an embodiment of the present invention; and
FIG. 14 is a surface atomic force micrograph of a substrate according to an embodiment of the present invention.

### DESCRIPTION OF EMBODIMENTS

Embodiments of this application relate to improvement on a silicon-based substrate and a substrate that is manufactured based on the silicon-based substrate. Silicon belongs to a cubic system. The embodiments of this application relate to silicon chips of a plurality of crystal planes: a silicon chip of a silicon (100) crystal plane, a silicon chip of a silicon (110) crystal plane, and a silicon chip of a silicon (111) crystal plane. For ease of understanding, these silicon chips are described as follows:

A silicon chip having the silicon (100) crystal plane is also referred to as a silicon chip (100). [100] is a crystal orientation index, and a normal line of the silicon (100) crystal plane is parallel to a [100] crystal orientation, in other words, the (100) crystal plane is perpendicular to the [100] crystal orientation.

A silicon chip having the silicon (110) crystal plane is also referred to as a silicon chip (110). [110] is a crystal orientation index, and a normal line of the silicon (110) crystal plane is parallel to a [110] crystal orientation, in other words, the (110) crystal plane is perpendicular to the [110] crystal orientation.

A silicon chip having the silicon (111) crystal plane is also referred to as a silicon chip (111). [111] is a crystal orientation index, and a normal line of the silicon (111) crystal plane is parallel to a [111] crystal orientation, in other words, the (111) crystal plane is perpendicular to the [111] crystal orientation.

It should be noted that an atomic column of crystal in various directions is referred to as a crystal orientation. If a coordinate system, namely, a crystal cubic system, is established on a unit cell, the foregoing [111] is coordinates of a direction vector. To be specific, [111] represents an atom on a straight line passing through an origin and a point x=1, y=1, and z=1. If the crystal is a body-centered cubic unit cell, the crystal orientation passes through an atom on a diagonal line of a cube.

Currently, a group III-V material (III-V material) is formed on a silicon-based substrate with the silicon (100) crystal plane through epitaxial growth. An epitaxial growth technology is a technology of growing, on a monocrystalline substrate (also referred to as a substrate chip), a monocrystalline layer that has a same crystal orientation as the substrate, and epitaxial growth means to grow the monocrystalline layer by using the epitaxial growth technology. A surface of the silicon-based substrate with the silicon (100) crystal plane is a plane. Because silicon and the group III-V material have different lattice constants and have a difference of a polar bond and a nonpolar bond, lattice mismatch and an antiphase domain are generated. Consequently, epitaxial growth of the group III-V material on the silicon-based substrate has a large amount of dislocation and disadvantages. In other words, atoms of the group III-V material are partially irregularly arranged on the silicon-based substrate, and further, it is difficult to epitaxially grow a high-quality group III-V material on the silicon-based substrate.

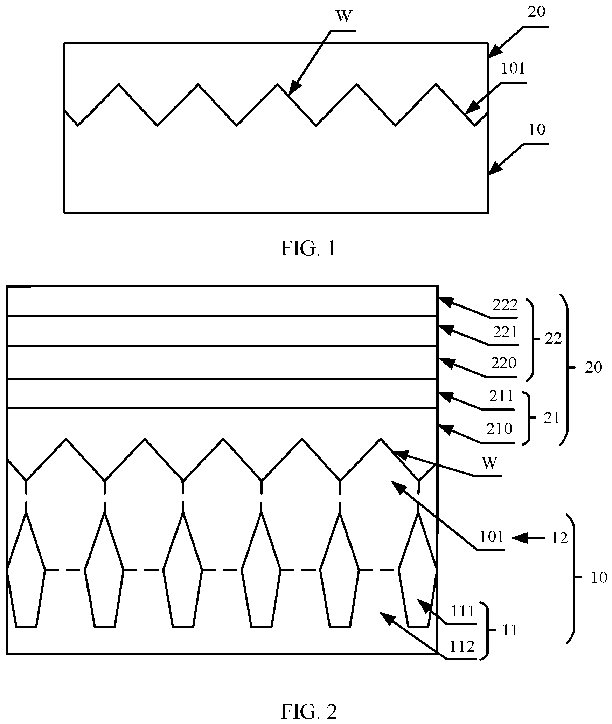

An embodiment of this application provides a substrate. FIG. 1 is a schematic diagram of a cross-section of a substrate according to an embodiment of this application. The substrate includes:
a silicon-based substrate 10 and a group III-V material layer 20 that is disposed on the silicon-based substrate 10.

As shown in FIG. 1, one surface of the silicon-based substrate 10 has periodic protrusion structures 101. The periodic protrusion structures 101 are a plurality of protrusion structures, and have a specific distribution period on the silicon-based substrate. There is an angle of inclination between a side face W of each protrusion structure 101 and a bottom surface, and dislocation of the silicon-based substrate 10 can be self-annihilated by using the angle of inclination, so that the dislocation is suppressed on the side face W of the protrusion structure of the silicon-based substrate, and the group III-V material layer 20 is disposed on the surface that is of the silicon-based substrate and that has the protrusion structures 101.

In conclusion, in the substrate provided in this embodiment of this application, because one surface of the silicon-based substrate is no longer a silicon (100) crystal plane, but has the periodic protrusion structures, dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

For example, the surface that is of the silicon-based substrate and that has the periodic protrusion structures 101 is a silicon (111) crystal plane. For example, the angle of inclination between the side face W of the protrusion structure and the bottom surface is 60 degrees. In this case, a cross-section of the surface that is of the silicon-based substrate and that has the periodic protrusion structures 101 may be a serrated structure formed by connecting equilateral triangles whose apex angles are 60 degrees. The silicon (111) crystal plane can effectively suppress the dislocation, so that the dislocation no longer grows upward, and the antiphase domain can be approximately completely suppressed on a 60° crystal plane, thereby facilitating epitaxial growth of the group III-V material.

Optionally, the protrusion structures in the silicon-based substrate are arranged in an equal-distance array in a specified direction. Shapes and sizes of the protrusion structures may be the same. A distance between every two protrusion structures may be 360 nm. The specified direction may be a row direction or a column direction of the silicon-based substrate. An extension direction of each protrusion structure may be perpendicular to the specified direction, and parallel to the bottom surface of the silicon-based substrate. For example, the extension direction is a direction perpendicular to a paper surface in FIG. 1. The distance between every two protrusion structures is a distance between specified points (for example, center points) of the two protrusion structures in the specified direction. In this way, the dislocation can be better suppressed, and every two adjacent protrusion structures are adjacent to each other (in other words, upper surfaces of the plurality of protrusion structures are consecutive surfaces), so that a stable silicon-based substrate structure can be implemented. It should be noted that the distance between every two protrusion structures may be set based on an experimental situation and an actual requirement. This is not limited in this embodiment of this application.

For example, FIG. 2 is a schematic diagram of a cross-section of a substrate according to an embodiment of this application. In the substrate, a silicon-based substrate 10 includes a silicon-based sub-substrate 11 having periodic grooves 111 on one surface, and a silicon intermediate layer 12 disposed on the surface that is of the silicon-based sub-substrate 11 and that has the grooves 111. The periodic grooves 111 are a plurality of grooves, and have a specific distribution period on the silicon-based sub-substrate. The periodic grooves 111 may be obtained by performing a mask process and a photolithography process on a silicon chip (100), and the periodic grooves 111 are all blind grooves.

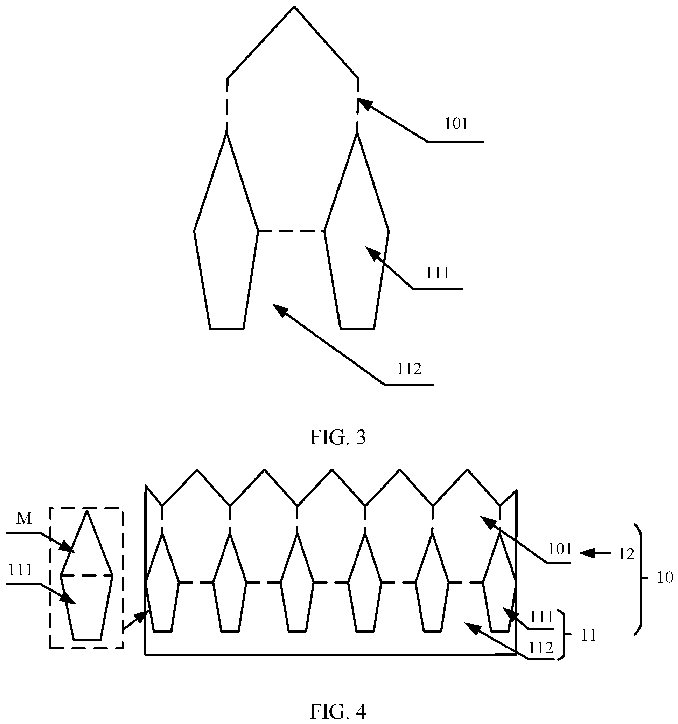

The silicon intermediate layer 12 includes periodic protrusion structures 101, in other words, the silicon intermediate layer 12 includes a plurality of protrusion structures. Each protrusion structure is located on a spacing structure 112 between two adjacent grooves, and the spacing structure 112 is used to separate two adjacent grooves. For example, the spacing structure may be referred to as a spacer or a blocking wall. For example, FIG. 3 is a partial enlarged view of the substrate. In the substrate, each protrusion structure 101 is located on a spacing structure 112 between two adjacent grooves. The protrusion structure may be obtained through growing by using an epitaxial growth technology. As shown in FIG. 2, the periodic protrusion structures 101 have a same arrangement period as periodic spacing structures 112. Side faces W of every two adjacent protrusion structures 101 are adjacent to each other. In other words, the side faces of every two adjacent protrusion structures intersect each other, so that there is no gap between the protrusion structures, and a stable silicon-based substrate structure can be ensured.

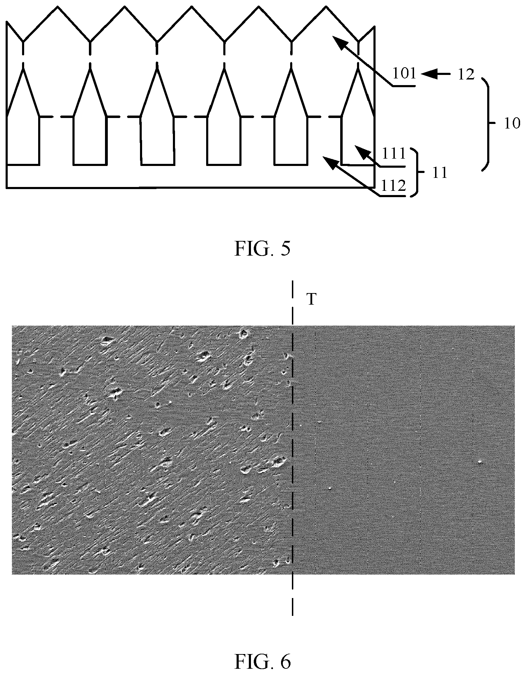

FIG. 4 and FIG. 5 are separately schematic diagrams of a cross-section of a silicon-based substrate according to an embodiment of this application. In an optional implementation, as shown in FIG. 4, a top width of each groove 111 is greater than a bottom width, for example, a cross-section of the groove 111 is an inverted trapezoid. For example, the top width of each groove may be 100 nm to 400 nm, and the bottom width may be 50 nm to 200 nm. Further, the top width of each groove may be 120 nm to 160 nm, and the bottom width may be 100 nm to 120 nm. In another optional implementation, as shown in FIG. 5, the surface that is of the silicon-based sub-substrate and that has the periodic grooves 111 is a silicon (110) crystal plane, and a side boundary of each groove is perpendicular to the bottom surface.

As shown in FIG. 4 and FIG. 5, in a specified direction, an arrangement period of each groove may be 200 nm to 800 nm, in other words, a distance between centers of every two adjacent grooves in the specified direction may be 200 nm to 800 nm. Further, the arrangement period of each groove may be 300 nm to 500 nm. A depth of each groove may be 200 nm to 1000 nm. Further, the depth of each groove may be 400 nm to 600 nm. An extension direction of each groove may be perpendicular to the specified direction, and parallel to the bottom surface of the silicon-based substrate. For example, the extension direction is a direction perpendicular to a paper surface in FIG. 4 and FIG. 5. The periodic grooves can effectively suppress an antiphase domain in a growing process of the silicon intermediate layer.

In the silicon-based substrate, when the silicon intermediate layer grows on the silicon-based sub-substrate, the silicon intermediate layer grows upward by using the spacing structure as a substrate. In the growing process of the silicon intermediate layer, every two adjacent protrusion structures transit from an initial non-adjacent state to a final adjacent state. Therefore, an irregular hollow structure is constructed in a finally formed silicon-based substrate structure. To further describe the hollow structure, FIG. 4 is an enlarged schematic diagram of the hollow structure. The hollow structure includes the grooves 111 and a gap M between every two protrusion structures 101. Hollow structures are arranged in an equal-distance array in the specified direction. Shapes and sizes of the hollow structures may be the same. The specified direction may be a row direction or a column direction of the silicon-based substrate, and an extension direction of each hollow structure may be perpendicular to the specified direction, and parallel to the bottom surface of the silicon-based substrate. For example, the extension direction is a direction perpendicular to the paper surface in FIG. 4. When temperature changes, a phenomenon of expansion and contraction occurs at a crystal layer, and further, dislocation occurs. The hollow structure is located between every two adjacent spacing structures, and is also located between every two adjacent protrusion structures, and can separate every two adjacent spacing structures, and can also separate every two adjacent protrusion structures. A part of stress is offset during expansion and contraction, thereby effectively suppressing dislocation caused by expansion and contraction of the silicon intermediate layer, reducing thermal expansion of the silicon-based substrate, and further improving quality of the finally formed group III-V material layer. Stress means interaction force generated between parts of an object when the object is deformed due to an external cause (a change of force, humidity, or a temperature field), and the stress is used to resist influence of the external cause, so that the object is restored from a deformed position to a position before deformation.

In a related technology, a manner of epitaxially growing the group III-V material on the silicon-based substrate with the silicon (100) crystal plane includes: directly epitaxially growing the group III-V material on a slanted substrate on the silicon (100) crystal plane; or epitaxially growing a group III-V on a virtual germanium-silicon substrate (to be specific, the substrate is not a pure silicon-based substrate, but a germanium-doped silicon-based substrate); or directly epitaxially growing the group III-V material on a silicon-based substrate with a diatomic step. Silicon-based substrates used when directly epitaxially growing the group III-V material on the slanted substrate on the silicon (100) crystal plane and the silicon-based substrate with the diatomic step cannot be manufactured through a related process (for example, a mask process and a photolithography process) in conventional complementary metal-oxide-semiconductor (Complementary Metal-Oxide-Semiconductor, CMOS) manufacturing, and need to be produced by using a complex process. Therefore, manufacturing costs are relatively high.

Based on the substrate provided in this embodiment of this application, the groove may be produced through the mask process and the photolithography process, and the protrusion structure may be produced by using the epitaxial growth technology. Therefore, the related process in the CMOS manufacturing may be compatible, a manufacturing process is simple, and manufacturing costs are relatively low.

Optionally, as shown in FIG. 2, a thickness of the silicon intermediate layer 12 is 300 nm to 800 nm, and the thickness of the silicon intermediate layer 12 is a thickness of the silicon intermediate layer by using a top platform of the grooves 111 as a reference surface. Further, the thickness of the silicon intermediate layer 12 may be 450 nm to 650 nm.

It should be noted that this embodiment of this application only provides a schematic description of values of parameters such as arrangement periods of the grooves and the protrusion structures, the depth of the groove, the top width of the groove, the bottom width of the groove, and the thickness of the silicon intermediate layer. In actual application, these parameters may be adjusted based on an experimental situation and an actual requirement, so that the group III-V material has a relatively good epitaxial growth effect on the silicon-based substrate. This is not limited in this embodiment of this application.

As shown in FIG.2, the group III-V material layer 20 may include a group III-V material buffer layer 21 and a group III-V dislocation filter layer 22 that are successively superposed on the surface that is of the silicon-based substrate 10 and that has the protrusion structures 101, the group III-V material buffer layer 21 is used to buffer lattice mismatch of the silicon-based substrate 10, and the group III-V dislocation filter layer 22 is used to filter dislocation of the silicon-based substrate 10.

For example, the group III-V material buffer layer 21 includes an aluminum arsenide (Aluminum arsenide, AlAs) crystal layer 210 and a gallium arsenide (gallium arsenide, GaAs) crystal layer 211 that are successively superposed on the surface that is of the silicon-based substrate 10 and that has the protrusion structures 101.

Because a melting point of A1 is approximately 660°C, and a melting point of Ga is approximately 30°C, a melting point of the AlAs crystal layer is higher than a melting point of the GaAs crystal layer. When the GaAs crystal layer is directly disposed on the protrusion structures, because the melting point of Ga is relatively low, an atom at the GaAs crystal layer moves on the silicon-based substrate, thereby generating dislocation. When the AlAs crystal layer is disposed on the protrusion structures, because the melting point of A1 is relatively high, an atom at the AlAs crystal layer has higher bond energy, and does not move on the silicon-based substrate, thereby avoiding dislocation caused by lattice mismatch. Therefore, if the AlAs crystal layer is first disposed on the protrusion structures of the silicon-based substrate, and then the GaAs crystal layer is disposed on the AlAs crystal layer, dislocation caused by directly disposing the GaAs crystal layer on the silicon-based substrate can be effectively avoided, thereby forming a high-quality group III-V material layer on the silicon-based substrate.

Optionally, a thickness of the group III-V material buffer layer 21 may be 0 nm to 600 nm. Further, the thickness of the group III-V material buffer layer 21 may be 200 nm to 600 nm. Surface roughness of the GaAs crystal layer may be 0.5 nm to 1.6 nm. Further, the surface roughness of the GaAs crystal layer may be 0.8 nm to 1.4 nm. The surface roughness may represent smoothness of a surface of a structure layer. A smaller value of the surface roughness indicates a smoother surface of the structure layer.

It should be noted that the group III-V material buffer layer may further include another structure provided that the lattice mismatch of the silicon-based substrate can be offset. For example, the group III-V material buffer layer includes an AlAs crystal layer and a gallium phosphide (galzium phosPhide, GaP) crystal layer that are successively superposed on the surface that is of the silicon-based substrate and that has the protrusion structures, where a thickness and a function of the AlAs crystal layer may be the same as those of the AlAs crystal layer of the group III-V material buffer layer. For another example, the group III-V material buffer layer includes only an AlAs crystal layer or a GaP crystal layer disposed on the surface that is of the silicon-based substrate and that has the protrusion structures.

For example, a thickness of the group III-V dislocation filter layer 22 may be 0 µm to 2 µm, and surface roughness of the group III-V dislocation filter layer 22 may be 0.5 nm to 1.6 nm. Further, the thickness of the group III-V dislocation filter layer may be 0.8 µm to 1.8 µm, and the surface roughness of the group III-V dislocation filter layer may be 0.8 nm to 1.4 nm.

As shown in FIG. 2, the group III-V dislocation filter layer 22 includes first quantum well structure layers 220 of m periods, where the first quantum well structure layers 220 of the m periods are superposed, the first quantum well structure layer 220 of each period includes an In_{0.15}Ga_{0.85}As crystal layer and a GaAs crystal layer that are successively superposed, and m is a positive integer. In_{0.15}Ga_{0.85}As represents InGaAs (indium gallium arsenide) in which a proportion of In (indium) is 15% and a proportion of Ga (gallium) is 85%.

It should be noted that, in the first quantum well structure layer, because lattice of In_{0.15}Ga_{0.85}As is larger than lattice of GaAs, stress is generated when the In_{0.15}Ga_{0.85}As crystal layer is first disposed on the group III-V material buffer layer, so that a stress field is formed. The stress field generated by the In_{0.15}Ga_{0.85}As crystal layer can offset stress generated by the dislocation, thereby suppressing the dislocation from continuing to extend upward.

For example, the group III-V dislocation filter layer 22 may further include second quantum well structure layers 221 of n periods and superlattice structures 222 of p periods that are superposed on the first quantum well structure layers 220 of the m periods, where the second quantum well structure layers 221 of the n periods are superposed, the superlattice structures 222 of the p periods are superposed, and n and p are positive integers. The second quantum well structure layer 221 of each period includes an In_{0.15}Al_{0.85}As crystal layer and a GaAs crystal layer that are successively superposed, and the superlattice structure 222 of each period includes an Al_{0.6}Ga_{0.4}As crystal layer and a GaAs crystal layer that are successively superposed. In_{0.15}Al_{0.85}As represents InGaAs (indium arsenide aluminum) in which a proportion of In (indium) is 15% and a proportion of A1 (aluminum) is 85%. Al_{0.6}Ga_{0.4}As represents AlGaAs (aluminum gallium arsenide) in which a proportion of A1 (aluminum) is 60% and a proportion of Ga (gallium) is 40%.

The In_{0.15}Al_{0.85}As crystal layer in the second quantum well structure layer has a better dislocation suppression effect than the In_{0.15}Ga_{0.85}As crystal layer in the first quantum well structure layer. However, because the melting point of Al is higher than that of Ga, if the In_{0.15}Al_{0.85}As crystal layer is directly formed on the group III-V material buffer layer, movement of an Al atom is relatively difficult, and when a location of the atom is incorrect, adjustment is difficult, and consequently, it is difficult to suppress extension of the dislocation. When the first quantum well structure layer is first grown on the group III-V material buffer layer, and then the second quantum well structure layer is grown on the first quantum well structure layer, the In_{0.15}Ga_{0.85}As crystal layer is used as a padding, and then the In_{0.15}Al_{0.85}As crystal layer is formed, so that the dislocation can be better suppressed, and therefore, a high-quality group III-V material layer is formed on the silicon-based substrate.

It should be noted that, in the second quantum well structure layer, specific dislocation may also occur when there are excessive Al atoms. Therefore, the second quantum well structure layer includes an In_{0.15}Al_{0.85}As crystal layer and a GaAs crystal layer that are successively superposed, so that the dislocation caused by excessive Al atoms can be effectively suppressed.

In the superlattice structure, the Al_{0.6}Ga_{0.4}As crystal layer and the GaAs crystal layer that are successively superposed may make a surface of a finally formed group III-V dislocation filter layer flat and smooth, to obtain a high-quality substrate.

Optionally, m=n=p=5. In this case, the thickness of the group III-V dislocation filter layer is relatively thin, and a better dislocation suppression effect can be implemented. It should be noted that, larger values of m, n, and p indicate a better dislocation suppression effect of the group III-V filter layer. In actual application of this application, proper period values of the first quantum well structure layers, the second quantum well structure layers, and the superlattice structure layers may be selected based on a requirement. This is not limited in this embodiment of this application.

FIG. 6 is a schematic diagram of comparison of surface scanning electron micrographs according to an embodiment of the present invention. In FIG. 6, a left region of a straight line T is a surface scanning electron micrograph of a substrate provided in a related technology, and a right region is a surface scanning electron micrograph of the substrate provided in this embodiment of this application. It can be seen from FIG. 6 that there are a large quantity of antiphase domains and high-density dislocation between a group III-V material layer and a silicon-based substrate in the substrate provided in the related technology, and in the substrate provided in this embodiment of this application, the group III-V material layer on the silicon-based substrate has an even height, and has no antiphase domain or obvious dislocation.

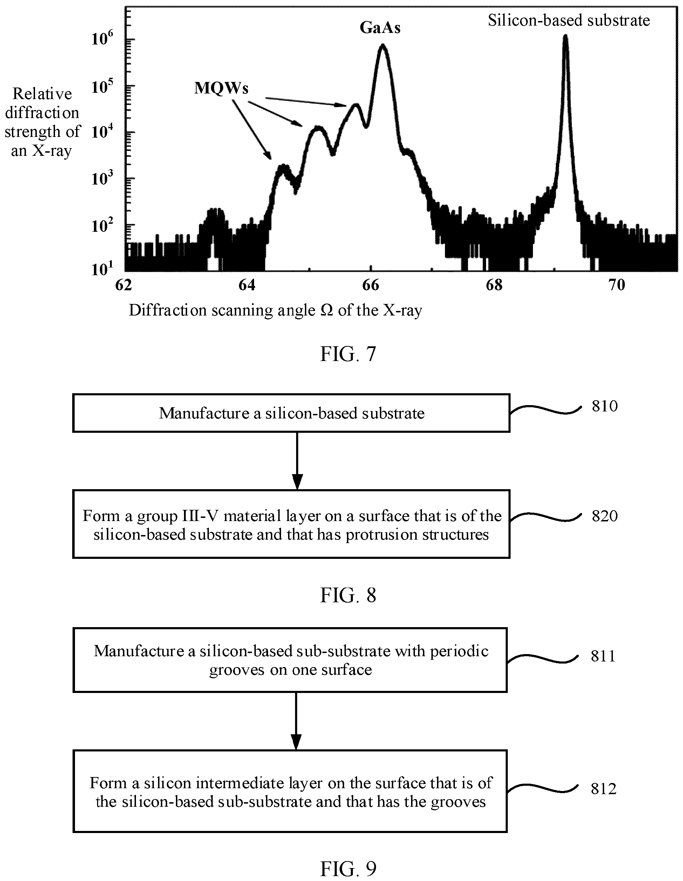

Further, FIG. 7 shows an X-ray diffraction spectrum of a substrate according to an embodiment of this application. In FIG. 7, a vertical coordinate represents relative diffraction strength of an X-ray, a horizontal coordinate represents a diffraction scanning angle Ω (Omega) of the X-ray, and a unit of Ω is "degree". MQWs means a group III-V dislocation filter layer structure in the substrate. A smaller full width at half maximum of the X-ray diffraction spectrum indicates higher quality of a corresponding group III-V material layer. It can be seen from FIG. 7 that a full width at half maximum of the X-ray diffraction spectrum of the substrate is approximately twice that of the silicon-based substrate. A full width at half maximum of the X-ray diffraction spectrum is less than that of a conventional substrate. Therefore, a structure of the substrate provided in this embodiment of this application can effectively reduce problems of lattice mismatch and an antiphase domain between the silicon-based substrate and the group III-V material, and quality is relatively high.

It should be noted that this embodiment of this application only provides a schematic description of values of parameters such as the thickness and the surface roughness of the group III-V material buffer layer and the thickness and the surface roughness of the group III-V dislocation filter layer. In actual application of this application, these parameters may be adjusted based on an experimental situation and an actual requirement, so that the group III-V material has a relatively good epitaxial growth effect on the silicon-based substrate. This is not limited in this embodiment of this application.

In conclusion, in the substrate provided in this embodiment of this application, one surface of the silicon-based substrate is no longer a silicon (100) crystal plane, but has the periodic protrusion structures, dislocation can be self-annihilated by using the protrusion structures, and dislocation caused by lattice mismatch and an antiphase domain is limited to the silicon-based substrate, so that the group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved, thereby improving a life span and a yield rate that are of a silicon-based optoelectronic device. In addition, the grooves on the silicon-based substrate may be produced through the mask process and the photolithography process, and the protrusion structure may be produced by using the epitaxial growth technology. Therefore, a related process in CMOS manufacturing may be compatible, a manufacturing process is simple, and manufacturing costs are relatively low.

An embodiment of this application provides a silicon-based substrate. Referring to FIG. 4 and FIG. 5, the silicon-based substrate includes:
a silicon-based sub-substrate 11 with periodic grooves 111 on one surface, and a silicon intermediate layer 12 disposed on the grooves 111, where the silicon intermediate layer 12 includes periodic protrusion structures 101, each protrusion structure is located on a spacing structure between two adjacent grooves, and side faces of every two adjacent protrusion structures are adjacent to each other, to ensure a stable silicon-based substrate structure.

For example, the surface that is of the silicon-based substrate and that has the periodic protrusion structures 101 is a silicon (111) crystal plane, and the surface that is of the silicon-based sub-substrate and that has the periodic grooves 111 is a silicon (110) crystal plane.

In conclusion, in the silicon-based substrate provided in this embodiment of this application, because one surface of the silicon-based substrate is no longer a silicon (100) crystal plane, but has the periodic protrusion structures, dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

A person skilled in the art may be clear that, for convenience and brevity of description, for a structure of the foregoing silicon-based substrate, refer to the silicon-based substrate in the substrate in the foregoing embodiment. Details are not described herein in this embodiment of this application.

An embodiment of this application provides a substrate manufacturing method. Referring to FIG. 8, the manufacturing method may include the following steps.

In step 810, a silicon-based substrate is manufactured.

One surface of the silicon-based substrate has periodic protrusion structures, and there is an angle of inclination between a side face of each protrusion structure and a bottom surface. Optionally, referring to FIG. 9, a method for manufacturing the silicon-based substrate in step 810 may include the following steps.

In step 811, a silicon-based sub-substrate with periodic grooves on one surface is manufactured.

Optionally, a silicon chip may be provided first, and a surface of the silicon chip is a silicon (100) crystal plane; a mask process and a photolithography process are then sequentially performed on the silicon chip; and then a mask is removed to obtain the silicon-based sub-substrate with the periodic grooves on one surface.

For example, a process of performing the mask process includes: forming a silicon dioxide (Silicon dioxide, SiO₂) layer on the silicon (100) crystal plane. The SiO₂ layer may be first formed on the silicon (100) crystal plane by using a chemical vapor deposition (Chemical Vapor Deposition, CVD) technology or an epitaxial growth technology, and the CVD technology may be a plasma enhanced chemical vapor deposition (Plasma Enhanced Chemical Vapor Deposition, PECVD) technology. A composition process (also referred to as a graphical process) is then performed on the SiO₂ layer once to obtain a SiO₂ mask, and the composition process includes photoresist coating, exposure, developing, etching, and photoresist stripping.

Correspondingly, a process of performing the photolithography process includes: performing, by using specified light, exposure processing on the silicon chip on which the SiO₂ mask is formed, or performing, by using a specified electron beam, bombardment processing on the silicon chip on which the SiO₂ mask is formed, where the specified light may be ultraviolet light, for example, deep ultraviolet light, and an exposure direction (to be specific, an irradiation direction) of the specified light is parallel to a [111] crystal orientation; and etching the processed silicon chip on which the SiO₂ mask is formed, to obtain the silicon-based sub-substrate. In this etching process, a dry etching process or a wet etching process may be used, for example, the silicon chip on which the SiO₂ mask is formed is etched by using a reactive ion etching technology in the dry etching process.

Correspondingly, a process of removing the mask includes: in an implementation, removing the SiO₂ mask on a surface by using the dry etching process; or in another possible implementation, removing the SiO₂ mask on the surface by using the wet etching process. For example, the SiO₂ mask is etched by hydrofluoric acid.

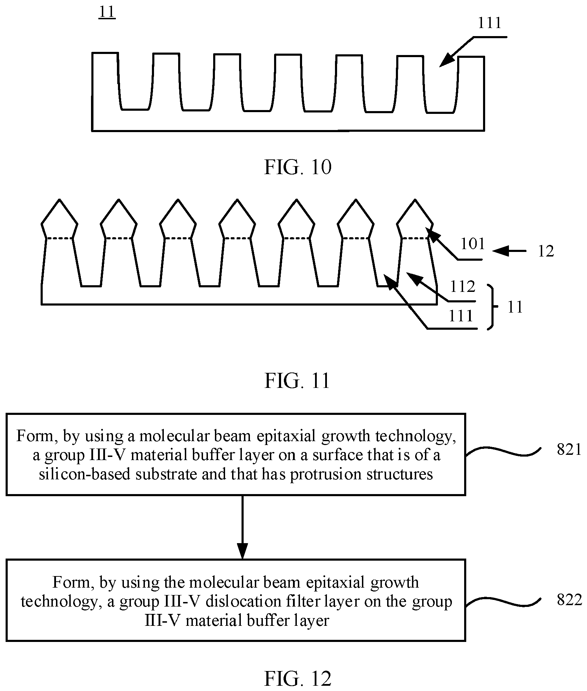

For example, FIG. 10 is a schematic diagram of a cross-section of a silicon-based sub-substrate 11 according to an embodiment of this application. A surface that is of the silicon-based sub-substrate and that has periodic grooves 111 is a silicon (110) crystal plane, in other words, a side boundary of the groove 111 is perpendicular to a bottom surface. In actual implementation of this application, a top width of the groove may also be greater than a bottom width, for example, a cross-section of the groove 111 is an inverted trapezoid. For a structure of the silicon-based sub-substrate, refer to the structure of the silicon-based sub-substrate provided in the foregoing embodiment. Details are not described in this embodiment of this application.

In step 812, a silicon intermediate layer is formed on the surface that is of the silicon-based sub-substrate and that has the grooves.

For example, the silicon intermediate layer may be formed, by using a molecular beam epitaxial growth technology, on the surface that is of the silicon-based sub-substrate and that has the grooves. The molecular beam epitaxial growth technology is one of epitaxial growth technologies. The molecular beam epitaxial growth technology is a technology in which a required crystalline material is placed in a spray furnace under an ultra-high vacuum condition, and the spray furnace is heated to form a molecular beam by using the crystalline material, and the molecular beam is sprayed onto the substrate from the spray furnace at a specific heat movement speed in a specific proportion, to perform crystal epitaxial growth. For example, the silicon intermediate layer may be formed in a growth environment of 500°C to 700°C. Further, the silicon intermediate layer may be formed in a growth environment of 550°C to 650°C, provided that a silicon intermediate layer that meets a requirement can be grown. Temperature of the growth environment is not limited in this embodiment of this application.

The silicon intermediate layer includes periodic protrusion structures. Each protrusion structure is located on a spacing structure between two adjacent grooves, and every two adjacent protrusion structures are adjacent to each other, to ensure a stable silicon-based substrate structure.

For example, FIG. 11 and FIG. 4 are schematic diagrams of a growing process of a silicon intermediate layer on a silicon-based sub-substrate according to an embodiment of this application. In this embodiment of this application, FIG. 11 and FIG. 4 are used as examples to describe a growing process of the silicon intermediate layer on a surface that is of the silicon-based sub-substrate and that has grooves. FIG. 11 shows an intermediate process of the growing process in FIG. 4. As shown in FIG. 11, when a growth temperature is 600°C, a silicon intermediate layer 12 of 250 nm is epitaxially grown on a silicon-based sub-substrate 11 with periodic grooves 111 on one surface by using a molecular beam epitaxial growth technology. It can be learned from FIG. 11 that when the silicon intermediate layer 12 of 250 nm is epitaxially grown on the silicon-based sub-substrate 11, a stable silicon (111) crystal plane is formed on a top of the silicon intermediate layer 12, in other words, periodic protrusion structures 101 are formed on tops of silicon intermediate layers 12. As shown in FIG. 4, when a growth temperature is 600°C, a silicon intermediate layer 12 of 500 nm is epitaxially grown on a silicon-based sub-substrate 11 with periodic grooves 111 on a surface by using a molecular beam epitaxial growth technology (in other words, another silicon intermediate layer of 250 nm is grown on the silicon intermediate layer 12 shown in FIG. 11). It can be learned from FIG. 4 that when the silicon intermediate layer 12 of 500 nm is grown on the silicon-based sub-substrate 11, stable silicon (111) crystal planes constructed on tops of silicon intermediate layers 12 are adjacent to each other, in other words, periodic protrusion structures 101 constructed on the tops of the silicon intermediate layers 12 are adjacent to each other, and an irregular hollow structure is constructed on a finally formed silicon-based substrate structure, and the hollow structure includes a groove 111 and a spacing M between every two protrusion structures 101. The hollow structure can effectively suppress dislocation caused by expansion and contraction, thereby further improving quality of a finally formed group III-V material layer.

In step 820, a group III-V material layer is formed on the surface that is of the silicon-based substrate and that has the protrusion structures.

For example, the group III-V material layer may be formed, by using a molecular beam epitaxial growth technology, on the surface that is of the silicon-based substrate and that has the protrusion structures. A group III-V material buffer layer is used to buffer lattice mismatch of the silicon-based substrate, and a group III-V dislocation filter layer is used to filter dislocation of the silicon-based substrate. When the group III-V material layer is formed, by using the molecular beam epitaxial growth technology, on the surface that is of the silicon-based substrate and that has the protrusion structures, as shown in FIG. 12, step 820 may include the following steps.

In step 821, the group III-V material buffer layer is formed, by using the molecular beam epitaxial growth technology, on the surface that is of the silicon-based substrate and that has the protrusion structures.

The group III-V material buffer layer includes an AlAs crystal layer and a GaAs crystal layer, and the GaAs crystal layer includes a first GaAs crystal sub-layer and a second GaAs crystal sub-layer.

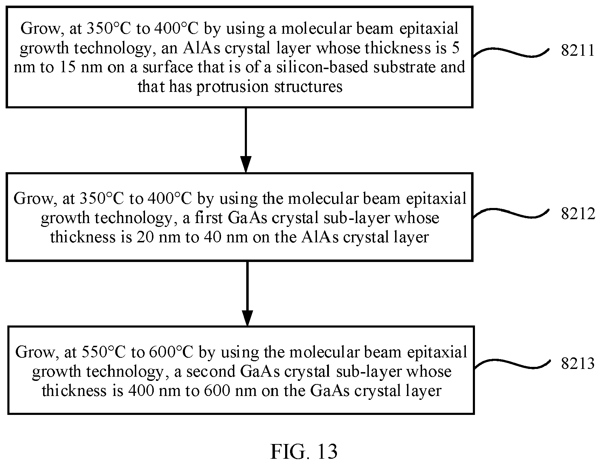

For example, the group III-V material buffer layer may be formed, by using a three-step method, on the surface that is of the silicon-based substrate and that has the protrusion structures. In this case, as shown in FIG. 13, a process of forming the group III-V material buffer layer may include the following steps.

In step 8211, an AlAs crystal layer whose thickness is 5 nm to 15 nm is grown, at 350°C to 400°C by using the molecular beam epitaxial growth technology, on the surface that is of the silicon-based substrate and that has the protrusion structures.

When the AlAs crystal layer is grown in a relatively low temperature environment, a rate of growing the AlAs crystal layer on the surface that is of the silicon-based substrate and that has the protrusion structures can be reduced, and further, each atom at the AlAs crystal layer can be grown in a correct location, thereby suppressing dislocation in a growing process of the AlAs crystal layer. In addition, when the AlAs crystal layer is first grown on the protrusion structure of the silicon-based substrate, dislocation caused by directly growing the GaAs crystal layer on the protrusion structure of the silicon-based substrate can be effectively avoided, thereby forming a high-quality group III-V material layer on the silicon-based substrate.

In step 8212, a first GaAs crystal sub-layer whose thickness is 20 nm to 40 nm is grown on the AlAs crystal layer at 350°C to 400°C by using the molecular beam epitaxial growth technology.

In step 8213, a second GaAs crystal sub-layer whose thickness is 400 nm to 600 nm is grown on the GaAs crystal layer at 550°C to 600°C by using the molecular beam epitaxial growth technology.

In step 8212 and step 8213, the first GaAs crystal sub-layer is grown in a low-temperature growth environment, so that a rate of growing the first GaAs crystal sub-layer on the surface that is of the silicon-based substrate and that has the protrusion structures can be reduced, and further, each atom at the first GaAs crystal sub-layer can be grown in a correct location. A high-quality second GaAs crystal sub-layer is then grown on the first GaAs crystal sub-layer in a high-temperature growth environment, so that dislocation caused by an antiphase domain can be suppressed, and a high-quality group III-V material layer is formed on the silicon-based substrate.

In step 822, a group III-V dislocation filter layer is formed on the group III-V material buffer layer by using the molecular beam epitaxial growth technology.

The group III-V dislocation filter layer includes superposed first quantum well structure layers of m periods, where the first quantum well structure layer includes an In_{0.15}Ga_{0.85}As crystal layer and a GaAs crystal layer that are successively superposed, and m is a positive integer. The group III-V dislocation filter layer may further include second quantum well structure layers of n periods and superlattice structures of p periods that are superposed on the first quantum well structure layers of the m periods, where n and p are positive integers. The second quantum well structure layer may include an In_{0.15}Al_{0.85}As crystal layer and a GaAs crystal layer that are successively superposed, and the superlattice structure may include an Al_{0.6}Ga_{0.4}As crystal layer and a GaAs crystal layer that are successively superposed.

For example, the first quantum well structure layers of the m periods may be first formed on the group III-V material buffer layer by using the molecular beam epitaxial growth technology, and then the second quantum well structure layers of the n periods are formed on the first quantum well structure layers, and finally, the superlattice structures of the p periods are formed on the second quantum well structure layers, to ensure an orderly structure of each layer.

A growth temperature of the first quantum well structure layer is 460°C to 510°C, and both a thickness of the In_{0.15}Ga_{0.85}As crystal layer and a thickness of the GaAs crystal layer are 10 nm. A growth temperature of the second quantum well structure layer is 460°C to 510°C, and both a thickness of the In_{0.15}Al_{0.85}As crystal layer and a thickness of the GaAs crystal layer are 10 nm. A growth temperature of the superlattice structure is 550°C to 600°C, and both a thickness of the Al_{0.6}Ga_{0.4}As crystal layer and a thickness of the GaAs crystal layer are 2 nm.

For example, when m=n=p=5, In_{0.15}Ga_{0.85}As crystal layers and GaAs crystal layers whose thicknesses are each 10 nm of five periods may be successively grown in a superposing manner on the group III-V material buffer layer at 480°C by using the molecular beam epitaxial growth technology, to obtain the first quantum well structure layers. In an optional implementation, a GaAs separation layer whose length is 150 nm to 250 nm may be first grown on the first quantum well structure layer at 550°C to 600°C, and then In_{0.15}Al_{0.85}As crystal layers and GaAs crystal layers whose thicknesses are each 10 nm of five periods are successively grown in a superposing manner on the GaAs isolation layer at 480°C, to obtain the second quantum well structure layers. In another optional implementation, In_{0.15}Al_{0.85}As crystal layers and GaAs crystal layers whose thicknesses are each 10 nm of five periods may be directly successively grown in a superposing manner on the first quantum well structure layers at 480°C, to obtain the second quantum well structure layers. Finally, Al_{0.6}Ga_{0.4}As crystal layers and GaAs crystal layers whose thicknesses are each 2 nm of five periods are successively grown in a superposing manner on the second quantum well structure layers at 580°C, to obtain the superlattice structures, so that a high-quality single crystal thin film that is group III-V material and whose surface roughness is 1 nm is obtained.

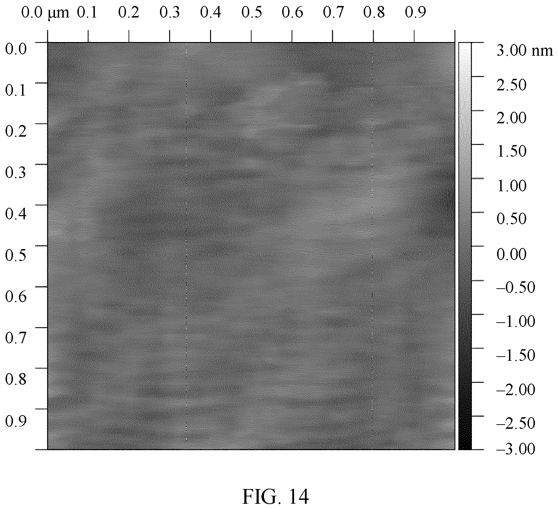

For example, FIG. 14 is a surface atomic force micrograph of a substrate on which a group III-V dislocation filter layer is formed according to an embodiment of this application. In FIG. 14, a vertical coordinate on the left and a horizontal coordinate on an upper part represent a size, a unit of the size is micron, a vertical coordinate on the right represents a surface height (in other words, surface flatness), and a unit of the surface height is nanometer. It can be learned from FIG. 14 that surface roughness of the substrate is approximately 0.8 nm, and a high-quality single crystal thin film of a group III-V material is formed on a surface of the substrate.

The foregoing temperature in an epitaxial growing process of each crystal layer is merely an example for description. In actual implementation of this application, another temperature range may also be used to perform epitaxial growth. This is not limited in this embodiment of this application.

It should be noted that a sequence of steps of the substrate manufacturing method provided in this embodiment of this application may be appropriately adjusted, and a step may be correspondingly added or deleted based on a situation.

In conclusion, in the substrate manufacturing method provided in this embodiment of this application, because one surface of the formed silicon-based substrate is no longer a silicon (100) crystal plane, but has the periodic protrusion structures, dislocation can be self-annihilated by using the protrusion structures, and dislocation caused by lattice mismatch and an antiphase domain is limited to the silicon-based substrate, so that the group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved, thereby improving a life span and a yield rate that are of a silicon-based optoelectronic device. In addition, the grooves on the silicon-based substrate may be produced through the mask process and the photolithography process, and the protrusion structure may be produced by using the epitaxial growth technology. Therefore, a related process in CMOS manufacturing may be compatible, a manufacturing process is simple, and manufacturing costs are relatively low.

A person skilled in the art may be clear that, for convenience and brevity of description, for a process of the foregoing substrate manufacturing method, refer to the structure of the substrate in the foregoing embodiment. Details are not described herein in this embodiment of this application.

An embodiment of this application provides a silicon-based substrate manufacturing method. For the manufacturing method, refer to step 810 and steps 811 and 812. Details are not described in this embodiment of this application.

An embodiment of this application provides an optoelectronic device, and the optoelectronic device includes a substrate and at least one optical film layer and/or at least one electrical film layer disposed on the substrate. The substrate is any substrate provided in the embodiments of this application.

In this embodiment of this application, the optoelectronic device is an optical device and/or an electrical device. For example, the optoelectronic device may be a quantum dot laser, a detector, an amplifier, a modulator, or a CMOS electrical device or waveguide device.

In conclusion, in the optoelectronic device provided in this embodiment of this application, because one surface of a silicon-based substrate of the substrate is no longer a silicon (100) crystal plane, but has periodic protrusion structures, dislocation can be self-annihilated by using the protrusion structures, and dislocation caused by lattice mismatch and an antiphase domain is limited to the silicon-based substrate, so that a group III-V material can maintain an orderly crystal structure when epitaxially growing on the silicon-based substrate. Therefore, problems of lattice mismatch and an antiphase domain between the silicon-based substrate and the group III-V material are reduced, and a yield rate of the group III-V material on the silicon-based substrate is improved.

A person skilled in the art may be clear that, for convenience and brevity of description, for a structure of the silicon-based substrate in the foregoing optoelectronic device, refer to the structure of the substrate in the foregoing embodiment. Details are not described herein in this embodiment of this application.

The term "and/or" in this application describes only an association relationship for describing associated objects and represents that three relationships may exist. For example, A and/or B may represent the following three cases: Only A exists, both A and B exist, and only B exists.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A substrate, comprising:
a silicon-based substrate, wherein one surface of the silicon-based substrate has periodic protrusion structures, and there is an angle of inclination between a side face of each protrusion structure and a bottom surface; and
a group III-V material layer disposed on the surface that is of the silicon-based substrate and that has the protrusion structures.

2. The substrate according to claim 1, wherein
the surface that is of the silicon-based substrate and that has the periodic protrusion structures is a silicon (111) crystal plane.

3. The substrate according to claim 2, wherein
the silicon-based substrate comprises a silicon-based sub-substrate with periodic grooves on one surface, and a silicon intermediate layer disposed on the surface that is of the silicon-based sub-substrate and that has the grooves, wherein the silicon intermediate layer comprises the periodic protrusion structures; and
each protrusion structure is located on a spacing structure between two adjacent grooves, and side faces of every two adjacent protrusion structures are adjacent to each other.

4. The substrate according to claim 3, wherein
the surface that is of the silicon-based sub-substrate and that has the periodic grooves is a silicon (110) crystal plane.

5. The substrate according to any one of claims 1 to 4, wherein the group III-V material layer comprises a group III-V material buffer layer and a group III-V dislocation filter layer that are successively superposed on the surface that is of the silicon-based substrate and that has the protrusion structures, the group III-V material buffer layer is used to buffer lattice mismatch of the silicon-based substrate, and the group III-V dislocation filter layer is used to filter dislocation of the silicon-based substrate.

6. The substrate according to claim 5, wherein
the group III-V material buffer layer comprises:
an AlAs crystal layer and a GaAs crystal layer that are successively superposed on the surface that is of the silicon-based substrate and that has the protrusion structures.

7. The substrate according to claim 5, wherein
the group III-V dislocation filter layer comprises superposed first quantum well structure layers of m periods, wherein the first quantum well structure layer of each period comprises an In_{0.15}Ga_{0.85}As crystal layer and a GaAs crystal layer that are successively superposed, and m is a positive integer.

8. The substrate according to claim 7, wherein the group III-V dislocation filter layer further comprises second quantum well structure layers of n periods and superlattice structures of p periods that are superposed on the first quantum well structure layers of the m periods, wherein the second quantum well structure layers of the n periods are superposed, the superlattice structures of the p periods are superposed, and n and p are positive integers;
the second quantum well structure layer of each period comprises an In_{0.15}Al_{0.85}As crystal layer and a GaAs crystal layer that are successively superposed; and
the superlattice structure of each period comprises an Al_{0.6}Ga_{0.4}As crystal layer and a GaAs crystal layer that are successively superposed.

9. The substrate according to claim 8, wherein m=n=p=5.

10. A silicon-based substrate, comprising:
a silicon-based sub-substrate with periodic grooves on one surface, and a silicon intermediate layer disposed on the grooves, wherein the silicon intermediate layer comprises the periodic protrusion structures;
each protrusion structure is located on a spacing structure between two adjacent grooves, and side faces of every two adjacent protrusion structures are adjacent to each other; and
a surface that is of the silicon-based substrate and that has the periodic protrusion structures is a silicon (111) crystal plane.

11. The silicon-based substrate according to claim 10, wherein
the surface that is of the silicon-based sub-substrate and that has the periodic grooves is a silicon (110) crystal plane.

12. A substrate manufacturing method, comprising:
manufacturing a silicon-based substrate, wherein one surface of the silicon-based substrate has periodic protrusion structures, and there is an angle of inclination between a side face of each protrusion structure and a bottom surface; and
forming a group III-V material layer on the surface that is of the silicon-based substrate and that has the protrusion structures.

13. The method according to claim 12, wherein
the surface that is of the silicon-based substrate and that has the periodic protrusion structures is a silicon (111) crystal plane.

14. The method according to claim 13, wherein
the manufacturing a silicon-based substrate comprises:
manufacturing a silicon-based sub-substrate with periodic grooves on one surface; and
forming a silicon intermediate layer on the surface that is of the silicon-based sub-substrate and that has the grooves, wherein the silicon intermediate layer comprises the periodic protrusion structures, each protrusion structure is located on a spacing structure between two adjacent grooves, and every two adjacent protrusion structures are adjacent to each other.

15. The method according to claim 14, wherein
the surface that is of the silicon-based sub-substrate and that has the periodic grooves is a silicon (110) crystal plane; and
the manufacturing a silicon-based sub-substrate with periodic grooves on one surface comprises:
providing a silicon chip, wherein a surface of the silicon chip is a silicon (100) crystal surface; and
etching the silicon chip through a deep ultraviolet photolithography process, to obtain the silicon-based sub-substrate.

16. The method according to claim 14, wherein
the forming a silicon intermediate layer on the surface that is of the silicon-based sub-substrate and that has the grooves comprises:
forming, by using a molecular beam epitaxial growth technology, the silicon intermediate layer on the surface that is of the silicon-based sub-substrate and that has the grooves.

17. The method according to any one of claims 12 to 16, wherein the forming a group III-V material layer on the surface that is of the silicon-based substrate and that has the protrusion structures comprises: forming, by using the molecular beam epitaxial growth technology, the group III-V material layer on the surface that is of the silicon-based substrate and that has the protrusion structures.

18. The method according to claim 17, wherein
the forming, by using the molecular beam epitaxial growth technology, the group III-V material layer on the surface that is of the silicon-based substrate and that has the protrusion structures comprises:
forming, by using the molecular beam epitaxial growth technology, a group III-V material buffer layer on the surface that is of the silicon-based substrate and that has the protrusion structures; and
forming, by using the molecular beam epitaxial growth technology, a group III-V dislocation filter layer on the group III-V material buffer layer, wherein
the group III-V material buffer layer is used to buffer lattice mismatch of the silicon-based substrate, and the group III-V dislocation filter layer is used to filter dislocation of the silicon-based substrate.

19. The method according to claim 18, wherein
the group III-V material buffer layer comprises an AlAs crystal layer and a GaAs crystal layer, wherein the GaAs crystal layer comprises a first GaAs crystal sub-layer and a second GaAs crystal sub-layer; and
the forming, by using the molecular beam epitaxial growth technology, a group III-V material buffer layer on the surface that is of the silicon-based substrate and that has the protrusion structures comprises:
growing, at 350°C to 400°C by using the molecular beam epitaxial growth technology, the AlAs crystal layer whose thickness is 5 nm to 15 nm on the surface that is of the silicon-based substrate and that has the protrusion structures;
growing, at 350°C to 400°C by using the molecular beam epitaxial growth technology, the first GaAs crystal sub-layer whose thickness is 20 nm to 40 nm on the AlAs crystal layer; and
growing, at 550°C to 600°C by using the molecular beam epitaxial growth technology, the second GaAs crystal sub-layer whose thickness is 400 nm to 600 nm on the first GaAs crystal sub-layer.

20. The method according to claim 18, wherein
the group III-V dislocation filter layer comprises superposed first quantum well structure layers of m periods, wherein the first quantum well structure layer comprises an In_{0.15}Ga_{0.85}As crystal layer and a GaAs crystal layer that are successively superposed, and m is a positive integer.

21. The method according to claim 20, wherein the group III-V dislocation filter layer further comprises second quantum well structure layers of n periods and superlattice structures of p periods that are superposed on the first quantum well structure layers of the m periods, wherein the second quantum well structure layers of the n periods are superposed, the superlattice structures of the p periods are superposed, and n and p are positive integers;
the second quantum well structure layer of each period comprises an In_{0.15}Al_{0.85}As crystal layer and a GaAs crystal layer that are successively superposed; and
the superlattice structure of each period comprises an Al_{0.6}Ga_{0.4}As crystal layer and a GaAs crystal layer that are successively superposed.

22. The method according to claim 20, wherein m=n=p=5;
a growth temperature of the first quantum well structure layer is 460°C to 510°C, and both a thickness of the In_{0.15}Ga_{0.85}As crystal layer and a thickness of the GaAs crystal layer are 10 nm; a growth temperature of the second quantum well structure layer is 460°C to 510°C, and both a thickness of the In_{0.15}Al_{0.85}As crystal layer and a thickness of the GaAs crystal layer are 10 nm; and a growth temperature of the superlattice structure is 550°C to 600°C, and both a thickness of the Al_{0.6}Ga_{0.4}As crystal layer and a thickness of the GaAs crystal layer are 2 nm.

23. An optoelectronic device, comprising: the substrate according to any one of claims 1 to 9, and at least one optical film layer and/or at least one electrical film layer disposed on the substrate.

24. The optoelectronic device according to claim 23, wherein the optoelectronic device is a quantum dot laser, a detector, an amplifier, a modulator, or a complementary metal-oxide-semiconductor CMOS electrical device or waveguide device.
